# EUROPEAN PATENT APPLICATION

(11) **EP 0 709 884 A2**
(43) Date of publication of application: **01.05.1996**
(21) Application number: 95307428.3
(22) Date of filing: 18.10.1995
(51) Int. Cl.: H01L 23/31, H01L 23/473

(54) **Microelectronic device having a package with internal ducting for the passage of cooling fluid**

(30) Priority: 31.10.1994 US 332222
(71) Applicant: AT&T Corp., New York, NY 10013-2412 (US)
(72) Inventor: Azar, Kaveh, Westwood, Massachusetts 02090 (US)
(74) Representative: Johnston, Kenneth Graham

(57) **Abstract**

Improved heat dissipation is achieved by a microelectronic device comprising: a package body having at least one interior duct formed therein through which a cooling fluid may pass; one or more integrated circuit dies disposed within the package body in a manner allowing the one more integrated circuit dies to be exposed to the cooling fluid; and connectors for connecting the one or more integrated circuit dies to an electrical circuit external to the microelectronic device. In an illustrative example of the invention, the interior duct is coupled to an external cooling fluid supply and return via openings on the sides of the package body, to advantageously provide the package with the same profile as a conventional package. In another illustrative example of the invention, the duct is separated from the integrated circuit die by a thin partition disposed in the package body. The thin partition is adapted to prevent direct contact between the cooling fluid and circuit die while offering minimal thermal resistance thereby allowing a high degree of heat transfer to the cooling fluid.

## Description

### Cross Reference to Related Application

United States patent application Serial Number 08/332223 was filed concurrently herewith.

### Technical Field

This invention relates to the cooling of heat-producing devices. More particularly, this invention relates to a microelectronic device having a package with internal ducting for the passage of cooling fluid.

### Background of the Invention

Effectively dissipating the heat produced by the operation of microelectronic devices, such as those utilizing semiconductor integrated circuit ("IC") dies, is an important concern in optimizing the performance of the circuitry in which those devices are used. In addition to optimizing performance, effective heat dissipation also helps to prolong the useful life of those devices and enhances overall system reliability.

IC dies are often encapsulated in a package made of plastic, ceramic, or glass in order to protect the IC die from mechanical and chemical hazards and assist in heat dissipation. A heat sink, typically made of metal having high thermal conductivity, may be attached to the outer surface of the package to further heat dissipation. Such heat sinks often utilize an array of elongated fins arranged on a common platform where the platform is then bonded or mechanically attached to the top of the IC package. Cooling fluid, such as air, conducts heat away from the IC package by means of forced or natural convection. Unfortunately, such cooling arrangements afford limited cooling capacity and thus, may not be able to adequately dissipate the heat generated by today's high-powered electronic components in certain applications. Furthermore, add-on heat sinks may adversely change the profile of the IC package which, in some cases, may require redesign of the circuit board on which the IC package is mounted.

### Summary of the Invention

Improved heat dissipation is achieved, in accordance with the invention, by a microelectronic device comprising: a package body having one or more interior ducts formed therein through which a cooling fluid may pass; one or more integrated circuit dies disposed within the package body in a manner allowing the one more integrated circuit dies to be exposed to the cooling fluid; and a connector for connecting the one or more integrated circuit dies to an electrical circuit that is external to the microelectronic device.

In an illustrative example of the invention, an interior duct is coupled to an external cooling fluid supply and return via openings on the sides of the package body to advantageously provide the package with the same profile as a conventional package. In another illustrative example of the invention, the duct is separated from the integrated circuit die by a thin partition disposed in the package body. The thin partition is adapted to prevent direct contact between the cooling fluid and circuit die while offering minimal thermal resistance thereby allowing a high degree of heat transfer to the cooling fluid.

### Brief Description of the Drawings

FIG. 1 shows a cross sectional view of a conventional microelectronic device.

FIG. 2 is a cutaway pictorial view of the microelectronic device shown in FIG. 1.

FIG. 3 shows an illustrative example of a microelectronic device having a package body with an interior duct, in accordance with the invention.

FIG. 4 shows a cross sectional view of the microelectronic device shown in FIG. 3.

FIG. 5 shows another cross sectional view of the microelectronic device shown in FIG. 3.

FIG. 6 shows an illustrative example of a microelectronic device in which the package body is assembled from a plurality of parts, in accordance with the invention.

FIGs. 7-10 show various illustrative ducting configurations, in accordance with the invention.

FIG. 11 shows an illustrative example of a microelectronic device having a partition between the ducting and an integrated circuit die, in accordance with the invention.

FIG. 12 is a schematic diagram of the microelectronic device shown in FIGs. 3-5 coupled to an illustrative example of an external cooling system.

FIG. 13 is a schematic diagram of the microelectronic device shown in FIGs. 3-5 coupled to an illustrative example of an external closed-loop cooling system.

### Detailed Description

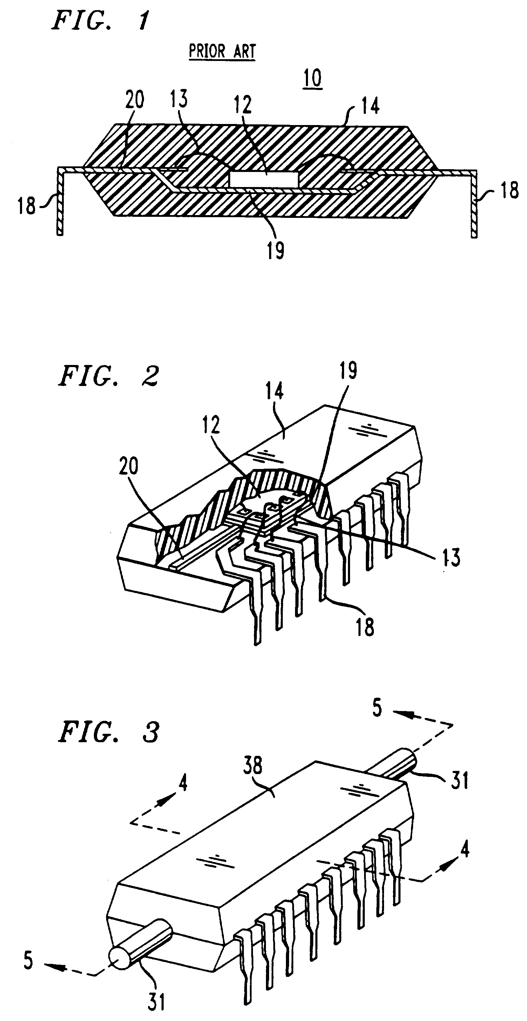

FIG. 1 shows a cross sectional view of a conventional microelectronic device 10 including an integrated circuit ("IC") die 12 and a conventional molded plastic package 14 having a standard profile and produced in accordance with known manufacturing processes and equipment. As used herein, the term "IC die" refers to a basic semiconductor device fabricated from a silicon wafer and having a plurality of electrical bonding pads. The term "package" refers to a device including a package body for housing the IC die, and a connector, such as a leadframe, for making the electrical connection between the IC die and a circuit that is external to the package. The combination of both a package and IC die is termed a "microelectronic device" herein.

There are two types of molded plastic packages known in the art: postmolded packages and premolded packages. FIG. 2 is a cutaway pictorial view of the microelectronic device 10 shown in FIG. 1 which is an example of a conventional postmolded package. Referring to FIGs. 1 and 2, an IC die 12 is mounted to a die-attach paddle portion 19 of a metal leadframe 20. The attachment is typically made using eutectic solders, polymer adhesives, silver-filled glass resins, or conductive epoxies. Wire bonds 13 are used to interconnect the bond pads of IC die 12 to the leads 18 of leadframe 20 which are fanned out around IC die 12. In other known arrangements, wire bonds are not used, and the IC die is directly attached to the fanout pattern of the leadframe in a so-called "flip chip" arrangement. As shown in FIGs. 1 and 2, leadframe 20 and IC die 12 are encapsulated in a thermosetting molding compound using a transfer or injection-type postmolding process. In the premolded package type (not shown), an IC die and leadframe may be inserted into a premolded plastic part, typically a base. The IC die is attached to the fanout pattern of the leadframe 20 through wire bonds or via direct attachment as described above. The fanout pattern connects to pins extending from the package to provide a leaded package, or to bonding pads providing a leadless package. An encapsulating material such as silicone or epoxy may be disposed around the IC die in the base of the premolded package. A lid made from plastic or metal, or a molded plastic package top, is then adhered to base to seal the package. In both package types, during electrical operation of IC die 12, the generated heat is conducted through the molded plastic material of package body 14 and through leads 18 of leadframe 20. Dissipation of heat from the IC die 12 in this manner thus restricts the rate at which heat can be removed from the IC die 12.

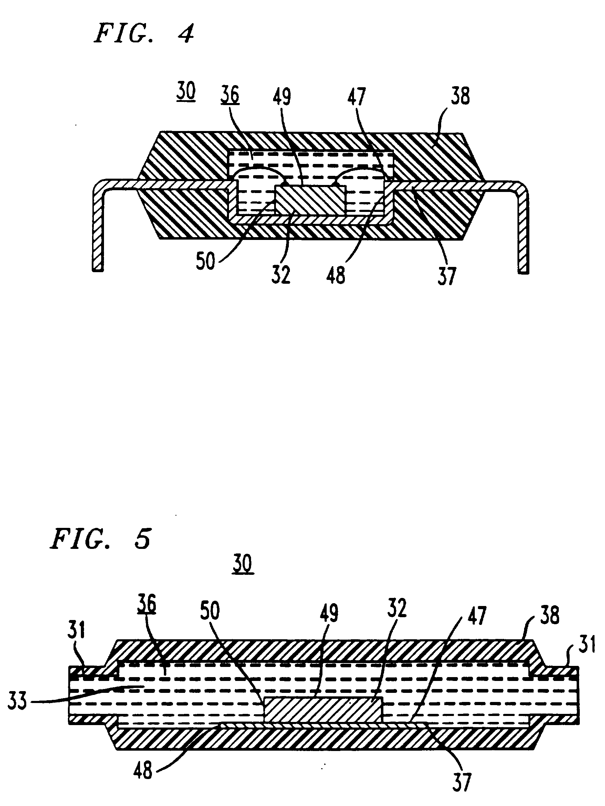

FIG. 3 is a pictorial view of an illustrative example of a microelectronic device 30, in accordance with the invention. As shown, microelectronic device 30 has the substantially the same profile as the conventional microelectronic device 10 shown in FIGs. 1 and 2. FIG. 4 shows a cross sectional view of microelectronic device 30 taken along section 4-4 in FIG. 3. FIG. 5 shows a cross sectional view of microelectronic device 30 taken along section 5-5 in FIG. 3. Referring then to FIGs. 3-5, microelectronic device 30 includes a package body 38 having an interior duct 33 which advantageously provides a direct heat conductive path between IC die 32 and a cooling fluid 36 which flows through the interior duct 33. The interior duct 33 also advantageously provides a direct heat conductive path between leadframe 37 on which IC die 32 is mounted and the cooling fluid 36. As will be appreciated by those skilled in the art, heat generated during the operation of IC die 32 not only flows to the top of IC die 32, but is also conducted through the bottom of IC 32 die to leadframe 37. As shown, interior duct 33 extends through the package body 38 to provide predetermined exposed areas of the top and side surfaces of leadframe 37 and the top and side surfaces of IC die 32 with a measure of cooling that was heretofore unachievable in conventional microelectronic devices. These exposed surfaces are typically shown as 47, 48, 49, and 50. Cooling fluid 36 may be, for example, a gas such as air, or a chemically inert, electrically non-conducting liquid. One suitable liquid cooling fluid is commercially available under the designation FLUORINERT FC-77 by the 3M Corporation. Although FIGs. 3-5 illustrate leadframe 37 as the means for connecting IC die 32 to an external circuit, leadframe 37 may optionally be replaced by a connector comprising a metallized circuit pattern and die connectors that are incorporated directly into the package body 38 in a manner that is known in the art. A direct connection may thus be made between the bonding pads of IC die 32 and the die connectors in package body 38 thus making wire bonds, as described above, unnecessary. IC die 32 may be attached to the metallized circuit pattern and connectors using conventional attachment means. It should be noted that while only a single IC die and interior duct are shown in FIGs. 3-5, it is intended that the scope of the invention include devices having a plurality of IC dies and interior ducts.

Package body 38 also includes couplers 31 which are used to connect cooling fluid carriers (not shown), which would typically comprise pipes, to microelectronic device 30 in a fluid-tight manner. The connection between the cooling fluid carriers and couplers 31 could be threaded, adhesive-bonded, brazed, welded, soldered, friction-fit, molded, or press fit according to the particular materials selected for the cooling fluid carriers and the package body 38. Couplers 31 are shown extending from, and being integrally formed with, package body 38 in FIGs. 3 and 5. However, this arrangement is merely illustrative as couplers 31 may take any form which having sufficient area to mate with the fluid carriers in the desired fluid-thight manner. Accordingly, couplers 31 may be, for example, individual parts which are joined to package body 38. It may also be desirable for couplers 31 to be disposed partly or entirely within package body 38.

Package body 38 may be formed from conventional package materials such as plastic, ceramic, metal, refractory glass, or combinations thereof. Package body 38 may be conveniently shaped for use with most package types, including for example, single-in-line packages, dual-inline packages, pin grid arrays, small outline packages, ball grid array packages, and quad flat packs. Multi-chip modules and three-dimensional packages having a plurality of chip carriers are also intended to fall within the scope of the invention. Package body 38 may be assembled from a plurality of individual parts, or may be formed as a unitary part where all the above described features of the package body are integrally formed as single piece. If a plurality of parts is utilized, then any of the above described materials may be suitable. If a unitary part is desirable in some applications, then plastic is a preferred material because of the ease in which it may be shaped by molding. The other described materials may still be utilized, however, they may require more operations to achieve the final form, and as a result may be less preferable for unitary package bodies.

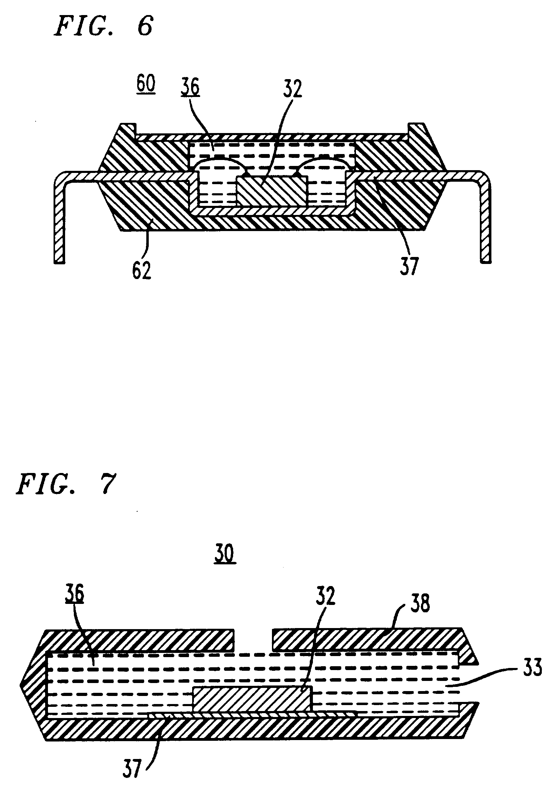

In the illustrative example of the invention shown in FIGs. 3-5, package body 38 is a plastic unitary part which is formed around leadframe 37 and IC die 32 in a conventional postmolding process. Interior duct 33 may be formed in package body 38 by using known molding methods which provide for hollow molded parts, for example, blowmolding, rotational molding, or transfer and injection molding using removable cores. Alternatively, interior duct 33 may be formed using postmolding operations such as punching, piercing, or drilling, although such methods are less preferred. Of course, interior duct 33 may also be readily formed if package body 38 is assembled from a plurality of parts. FIG. 6 shows an illustrative example of the invention using such an arrangement in which package body 60 comprises a base 62 and lid 64. It is emphasized that package body 60 in this illustrative example may be formed from any of the materials described above and is not limited to plastics.

Interior duct 33 may be arbitrarily shaped, although in most implementations of the invention it will have a simple, non-varying cross sectional configuration, for example, circular or rectangular, in order to simplify fabrication of microelectronic device 30. Those skilled in the art will also appreciate that the actual shape of interior duct 33 is a less important factor in effectively adapting the principles of the invention to a particular integrated circuit application than certain design choices such as type of cooling fluid used, the cooling fluid flow rate, and the overall size and number of the ducts employed. Of course, application parameters such as the number of IC dies to be cooled, and the rate at which heat is produced by the IC dies will greatly influence the making of these design choices. Thus, it will be apparent that these design choices may be made in such a manner to accommodate the number of IC dies, the amount of heat produced, and the like, according to the well known principles of heat transfer and fluid dynamics. In the illustrative examples of the invention shown, a single duct 33 is shown as having a substantially rectangular cross section with a height that is approximately equal to the width of IC die 32 and a width slightly larger than the width of IC die 32.

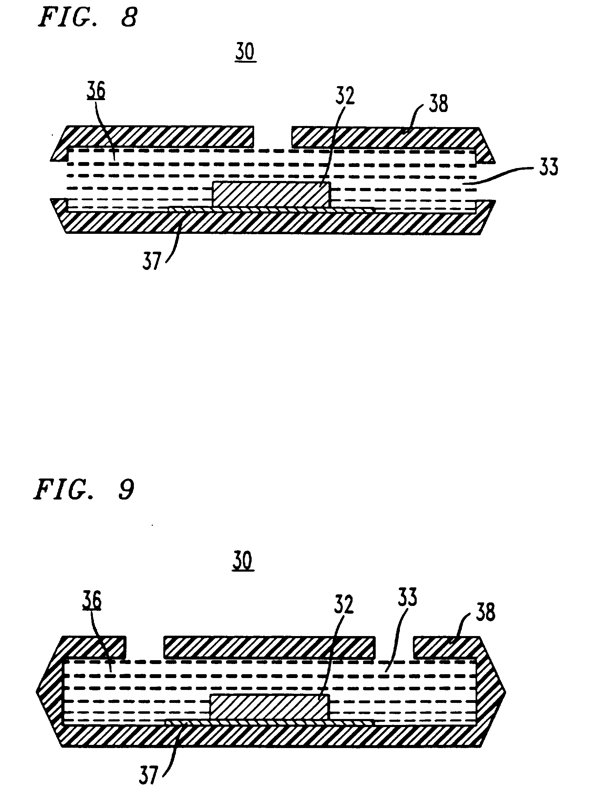

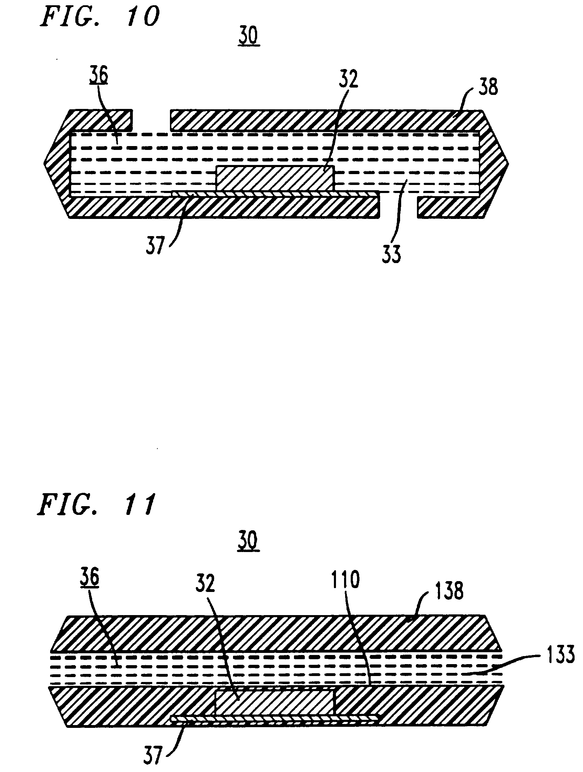

As shown in FIG. 5, interior duct 44 is arranged to longitudinally pass through package body 38 from one side of package body 38 to another side. Thus, a vector indicating the direction of the flow of cooling fluid 44 in package body 38 is parallel the top surface of IC die 32. However, this ducting configuration is merely illustrative as other arrangements are intended to fall within the scope of the invention. FIGs. 7-10 show several examples of other ducting configurations. FIG. 7 shows duct 33 having an entrance in the top of package body 38 and an exit on one side of package body 38. This duct configuration provides for a "jet impingement" arrangement where cooling fluid 36 impinges the top surface of IC die 32 and leadframe 37 so that the vector indicating the direction of the cooling fluid flow 44 in package body 38 is orthogonal to the top surface of IC die 32. Jet impingement generally provides a greater degree of heat transfer to cooling fluid 44 compared with the longitudinal duct configuration shown in FIG. 3. Therefore, jet impingement may be a desirable method of increasing the heat transfer to the cooling fluid 44 from IC die 32 and leadframe 36 in certain applications of the invention where maintaining a low profile is a secondary consideration. It should be noted that the entrance and exit for duct 42 could be reversed in FIG. 7 so that fluid enters at the side of package body 38 and exits at the top. FIG. 8 shows interior duct 33 having openings -- where an opening can be used as either an entrance or exit to the duct -- on the top and sides of package body 38. FIG. 9 shows openings only on the top of package body 3 8. FIG. 10 shows openings on the top and bottom of package body 38. It should be apparent that the number and location of duct openings can take various configurations according to the requirements of a particular application.

FIG. 11 shows another illustrative example of microelectronic device, in accordance with the invention. In this illustrative example, a partition 110 is included in package body 138 between interior duct 133 and IC die 32. Partition 110 prevent direct contact between cooling fluid 36 and IC die 32 which may be desirable in some applications of the invention. Partition 110 is selected to be sufficiently thin so as to offer minimal resistance to heat transfer between cooling fluid 36 and IC die 32. Advantageously, the use of partition 110 in this illustrative example of the invention allows interior duct 133 to readily formed using transfer or injection molding techniques since core complexity is reduced as a result of the uniformity of the duct's cross-section from entrance to exit.

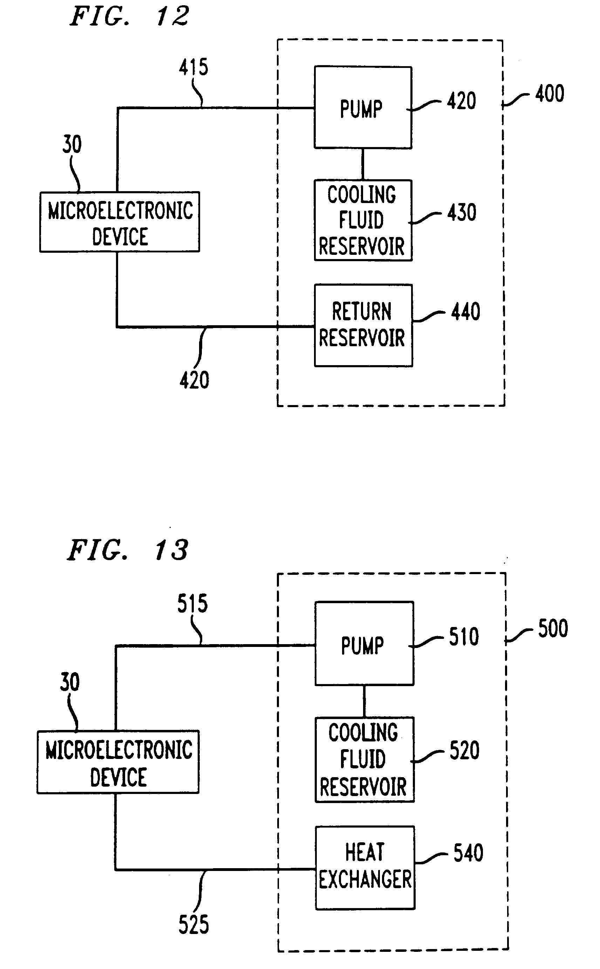

Referring now to FIG. 12, there is shown a schematic diagram of microelectronic device 30 coupled to an illustrative example of an external cooling system 400 via supply line 415 and return line 420. Cooling system 400 may be, for example, a system-level cooling system which is typically centralized so as to provide cooling for devices at different locations within the system. It is noted that the term "system" as used herein refers to the overall system to which microelectronic device 30 belongs. A system could be, for example, a computer, an audio amplifier, a telephone switching system, and the like. One example of a system-level cooling system is disclosed in United States patent 4,865,123 by Kawashima et al., the disclosure of which is incorporated by reference herein. Alternatively, it may be desirable to employ a circuit-pack-level cooling system. The term "circuit-pack" as used herein refers to devices which typically comprise a plurality of interconnected integrated circuits mounted on a common substrate. These devices are often called "cards" or "boards" which are installed in slots at the system level. Modem cards and video boards for personal computers are well known examples of circuit packs. Such a circuit-pack-level cooling system is disclosed in my co-pending United States patent application Serial Number (K. Azar Case 14) filed on the same day as the present application, the disclosure of which is incorporated by reference herein. As shown in FIG. 12, cooling fluid (not shown) from cooling fluid reservoir 430 is pumped through supply pipe 415 to microelectronic device 30 by pump 420. After cooling microelectronic device 30, the cooling fluid exits microelectronic device 30 and flows through return pipe 420 to return reservoir 440. It is evident that cooling system 400, as shown in FIG. 12, is an open loop system where the cooling fluid makes a single pass through microelectronic device 30 and is not recirculated. As such, when the cooling fluid is air, then return reservoir 440 could be replaced by a vent to the surrounding atmosphere, if cooling fluid is water, then return reservoir 440 could be replaced by a drain. FIG. 13 shows an example of a closed loop cooling system 500 coupled to microelectronic device 30. Cooling fluid (not shown) from cooling fluid reservoir 520 is pumped through supply pipe 515 to microelectronic device 30 by pump 510. After cooling microelectronic device 30, the cooling fluid exits microelectronic device 30 and flows through return pipe 525 to heat exchanger 540 and then back to cooling fluid reservoir 520.

It will be understood that the particular techniques described above are only illustrative of the principles of the present invention, and that various modifications could be made by those skilled in the art without departing from the scope and spirit of the present invention, which is limited only by the claims that follow. For example, conventional heat sinks may be attached to the package body, the IC die, or both, to further increase heat dissipation from the IC die.

## Claims

1. A microelectronic device, comprising:
a package body having at least one interior duct formed therein through which a cooling fluid may flow;
at least one integrated circuit die disposed within said package body so that said at least one integrated circuit is exposed to said cooling fluid; and
at least one connector for connecting said at least one integrated circuit die to an electrical circuit that is external to said microelectronic device.

2. The apparatus as claimed in claim 1, wherein said package body is a unitary part, or includes a base and a lid.

3. The apparatus as claimed in claim I, wherein said connector comprises a leadframe, or is a metallized circuit pattern disposed in said package body.

4. The apparatus as claimed in claim 1, wherein said at least one interior duct has at least one opening either on at least one side of said package body, or on the top of said package body, or on the bottom of said package body.

5. The apparatus as claimed in claim 1 wherein said cooling fluid is a gas, or a liquid, or an inert, electrically non-conducting liquid.

6. The apparatus of claim 1, wherein said package body is formed from a material selected from plastic, glass, metal, ceramic, or combination thereof.

7. The apparatus as claimed in claim 1, wherein said package body is shaped either as a dual-in-line package body, or as pin grid array package body, or as a small-outline package body, or as a quad flat pack package body.

8. The apparatus as claimed in claim 1, wherein said package body is formed using a molding process selected from injection molding, transfer molding, blowmolding, or rotational molding.

9. The apparatus as claimed in claim I, further including a partition formed with said package body between said at least one interior duct and said at least one integrated circuit such that said exposure of said integrated circuit die to said cooling fluid is made through said partition.

10. An apparatus, comprising
at least one microelectronic device including
a package body having at least one interior duct formed therein through which a cooling fluid may flow;
at least one integrated circuit die disposed within said package body so that said at least one integrated circuit is exposed to said cooling fluid;
connectors for connecting said at least one integrated circuit die to an electrical circuit external to said microelectronic device; and
a cooling system coupled said microelectronic device.

11. The apparatus as claimed in claim 10, wherein said cooling system is either a closed-loop cooling system, or an open-loop cooling system.

12. The apparatus as claimed in claim 10, further including at least one coupler for coupling said package body to said cooling system.

13. The apparatus as claimed in claim 1 wherein said package body is a multi-chip module, or a three-dimensional package.

14. The apparatus as claimed in claim 10, further including at least one heat sink coupled either to said at least one integrated circuit die, or to said package body, or to said at least one integrated circuit die.

15. The apparatus as claimed in claim 1, wherein said package body is arranged as a ball grid array.
